# DEMANDE DE BREVET EUROPEEN

(11) **EP 0 966 078 A1**
(43) Date de publication de la demande: **22.12.1999**
(21) Numéro de dépôt: 99401448.8
(22) Date de dépôt: 14.06.1999
(51) Int. Cl.: H01S 3/085, G02F 2/00

(54) **Composant optique à semiconducteur et amplificateur et convertisseur de longueurs d'onde constitués par ce composant**

(30) Priorité: 15.06.1998 FR 9807493
(71) Demandeur: ALCATEL, 75008 Paris (FR)
(72) Inventeur: Emery, Jean-Yves, 91120 Palaiseau (FR); Gaborit, Fabienne, 91470 Limours (FR); Janz, Christopher, 92130 Issy les Moulineaux (FR); Dorgeuille, Francois, 75004 Paris (FR); Dagens, Béatrice, 75014 Paris (FR)
(74) Mandataire: Fournier, Michel Robert Marie

(57) **Abrégé**

Dans la puce semiconductrice d'un amplificateur ou convertisseur selon cette invention une structure active (10) comporte plusieurs couches actives telles que (11 et 12) qui sont superposées les unes aux autres et qui présentent une différence de composition d'une couche à l'autre. Cette différence de composition entraine un décalage spectral entre des bandes de gain respectives de ces couches et permet d'élargir la bande de gain de l'amplificateur ou la bande passante optique du convertisseur.

Cette invention trouve notamment application dans les réseaux de télécommunication à fibres optiques.

## Description

La présente invention concerne un composant apte à constituer notamment un amplificateur optique à semiconducteur. Un tel amplificateur comporte une structure active constituée par une couche active non dopée ou par plusieurs telles couches superposées les unes aux autres selon une direction verticale. Cette structure constitue en même temps un guide d'ondes guidant les ondes lumineuses selon une direction longitudinale. Elle est interposée entre deux couches d'injection ayant des dopages de type p et n respectivement. Un courant de pompage circule selon ladite direction verticale pour injecter des porteurs p et dans la ou les couches actives respectivement à partir de ces deux couches d'injection. La présence de ces deux types de porteurs est en effet nécessaire pour permettre à ces couches actives d'amplifier la lumière qui les parcourt grâce à des recombinaisons des porteurs d'un type avec ceux de l'autre type.

De tels amplificateurs sont typiquement utilisés dans les noeuds des réseaux de télécommunication à fibres optiques. La capacité de transmission d'information d'un tel réseau est accrue par un multiplexage en longueur d'onde qui permet de transmettre plusieurs ondes porteuses sur une même fibre optique. Au sein d'un noeud du réseau, un même amplificateur est alors utilisé pour conférer une puissance convenable à toutes ces ondes. La capacité du réseau est d'autant plus grande que l'intervalle spectral occupé ou susceptible d'être occupé par ces ondes est large. Or l'amplificateur ne peut conférer cette puissance à ces ondes que dans la mesure où leurs longueurs d'onde sont comprises dans une bande de gain de cet amplificateur. C'est pourquoi le besoin a souvent été ressenti qu'une telle bande de gain soit élargie.

Un tel élargissement a été obtenu dans un premier amplificateur connu qui est un amplificateur à guide d'ondes constituant une partie amplificatrice d'un oscillateur laser accordable. Cet oscillateur est décrit dans un document de brevet US-A-4 680 769 (Miller). Sa partie amplificatrice comporte deux dites structures actives qui sont constituées chacune par une couche active et qui se succèdent selon la direction longitudinale, c'est à dire que la lumière parcourt successivement ces deux structures et que deux courants de pompage sont fournis respectivement pour ces deux structures.

L'élargissement de la bande de gain de cet amplificateur résulte du fait que les couches constituant ces deux structures actives sont constituées de deux matériaux différents. Cette différence de composition entraine une différence entre les deux intervalles énergétiques existant respectivement dans ces deux couches entre la bande de valence et la bande de conduction, ces bandes étant celles dans lesquelles se situent les niveaux d'énergie susceptibles d'être occupés par les électrons. Or ces intervalles énergétiques définissent pour le matériau actif une longueur d'onde caractéristique qui constitue une limite supérieure de la bande de gain et qui définit ainsi la position de cette bande dans le spectre des longueurs d'onde. Il en résulte que les bandes de gain des deux structures actives sont décalées l'une par rapport à l'autre. Elles se recouvrent cependant partiellement l'une l'autre. La longueur d'onde émise par l'oscillateur peut être accordée grâce au fait que, dans chacune des deux structures, les gains présentés par cette structure pour les longueurs d'onde incluses dans la bande de gain de cette structure sont commandés par le courant de pompage fourni à cette dernière. Le choix des deux courants de pompage permet alors de faire apparaître un maximum de gain pour une longueur d'onde qui peut être choisie dans l'intervalle entre les longueurs d'onde centrales des deux bandes de gain propres aux deux structures actives.

S'il devait être utilisé en tant qu'amplificateur à bande de gain élargie, ce premier amplificateur connu présenterait notamment l'inconvénient de nécessiter le réglage de deux courants de pompage.

Il est maintenant largement connu que la bande de gain d'un amplificateur à semiconducteur à guides d'ondes est plus large lorsque la structure active de cet amplificateur est constituée de puits quantiques que lorsqu'elle est constituée d'une couche active massive telle que celle de chacune des deux structures actives dudit premier amplificateur connu. Un telle couche massive est constituée d'un matériau dit en anglais "bulk material" pour "matériau massif". Les puits d'une structure à puits quantiques présentent la forme de couches actives minces qui sont superposées tout en étant séparées les unes des autres par des barrières dont les épaisseurs sont comparables à celles de ces puits. Dans le but de confiner les fonctions d'onde des porteurs de charge dans chacun de ces puits le matériau constitutif d'un tel puits est choisi pour avoir un intervalle énergétique bien inférieur à celui des barrières. La différence entre ces deux intervalles est au moins égale à 100 meV et typiquement voisine de 250 ou 300 meV. L'épaisseur de chaque tel puits est typiquement de l'ordre de 10 nm alors que celle d'une couche massive est typiquement de l'ordre de 100 nm. C'est pourquoi, pour obtenir une même épaisseur totale de matériau actif, une structure active à puits quantiques est typiquement constituée d'un nombre de puits de l'ordre de dix. La bande de gain de la structure ainsi constituée est élargie grâce au fait que la faible épaisseur de ces puits augmente la densité des niveaux énergétiques susceptibles d'être occupés par les électrons dans ces puits. Il reste cependant souhaitable d'augmenter encore la largeur de la bande de gain d'un tel amplificateur.

Un tel élargissement est réalisé dans un deuxième amplificateur connu qui est un amplificateur à semiconducteur à guide d'ondes dont la structure active est constituée de puits quantiques. Ce deuxième amplificateur connu a été décrit dans une communication du Topical Meeting on Quantum Optoelectronics, Salt Lake City, USA, March 1991, O.S.A. 1991 Tech. Digest Ser..., "Broadband GaAs/AlₓGa₁₋ₓAs Multi-Quantum Well LED", A.J. Moseley, D.J. Robbins, C. Meaton, R.M. Ash, R. Nicklin, P. Bromley, R.R. Bradley, A.C. Carter, C.S. Hong and L. Figueroa. L'élargissement de sa bande de gain résulte du fait que les puits quantiques de la structure active sont constitués de matériaux actifs ayant des compositions différentes de puits à puits. Comme précédemment expliqué de telles différences de composition ont pour effet que les puits successifs ont des bandes de gain décalées les unes par rapport aux autres. Le décalage entre deux puits successifs est suffisamment petit pour que les bandes de gain respectives de ces deux puits se recouvrent partiellement, ce qui permet d'obtenir pour la structure active une bande de gain composite sensiblement continue. Cette bande peut être très large parce qu'elle inclut les bandes de gain respectives de tous les puits. Ce deuxième amplificateur connu présente notamment les inconvénients suivants :
- Sa réalisation est complexe.
- L'obtention d'un gain souhaité dans chacune des bandes de gain des diverses couches actives exige que la circulation du courant de pompage crée une densité suffisante de porteurs de charge aussi bien positifs que négatifs dans chacune de ces couches. Cette exigence est facilement satisfaite pour les porteurs de charge négatifs constitués par les électrons parce que la grande mobilité de ces derniers leur permet d'atteindre rapidement les puits quantiques les plus éloignés de la couche d'injection de type n à partir de laquelle ils ont été injectés dans la structure active. Il n'en est malheureusement pas de même pour les porteurs de charge positifs constitués par des trous dont il est bien connu que la mobilité est bien moindre. Ces trous pourraient disparaitre en trop grand nombre par recombinaison dans les puits les plus proches de la couche d'injection de type p de laquelle ils proviennent, et par suite ne pas être injectés en nombre suffisant dans les puits les plus éloignés de cette couche. Il pourrait en résulter une insuffisance ou une trop grande instabilité du gain dans les bandes de gain des couches actives les plus proches de la couche d'injection de type n. Pour éviter qu'un tel défaut d'uniformité de l'injection de trous provoque une telle insuffisance ou instabilité du gain de certains puits, tous les puits quantiques et toutes les barrières de ce deuxième laser connu reçoivent un fort dopage de type p qui augmente artificiellement en tous points la densité des trous. Ce fort dopage présente l'inconvénient de compliquer encore la réalisation de l'amplificateur et surtout d'augmenter l'absorption de la lumière dans la structure active. Or une telle perte de lumière doit être compensée par une augmentation de l'intensité du courant de pompage ce qui provoque une augmentation correspondante de la puissance thermique à évacuer.

La présente invention a notamment pour but de permettre de réaliser simplement un amplificateur optique à semiconducteur ayant une bande de gain élargi et elle a notamment pour objet un tel amplificateur.

De même que le deuxième amplificateur connu qui a été décrit ci-avant, l'amplificateur objet de cette invention comporte un guide d'ondes faisant partie d'une puce semiconductrice constituée de couches s'étendant selon des directions horizontales de cette puce et formant une succession présentant une continuité cristalline selon une direction verticale de cette puce. Ce guide d'ondes s'étend selon une dite direction horizontale. Il inclut des matériaux actifs ayant des compositions et des intervalles énergétiques respectifs les rendant aptes à amplifier des ondes optiques se propageant dans ce guide. Ces matériaux actifs présentent selon ladite direction verticale une variation de composition entrainant une variation d'intervalle énergétique.

L'amplificateur objet de cette invention est caractérisé par le fait que certains au moins desdits matériaux actifs sont inclus dans ledit guide d'ondes sous la forme de matériaux massifs.

Conformément à l'usage on entend ici par matériaux massifs des matériaux qui ne forment pas des puits quantiques, c'est à dire plus précisément que ces matériaux forment au moins une couche dans l'épaisseur de laquelle ladite variation d'intervalle énergétique est au plus égale à 100 meV, cette épaisseur étant au moins égale à 20 nm et étant mesurée selon ladite direction verticale.

Cette invention concerne non seulement les amplificateurs optiques mais aussi les convertisseurs de longueurs d'onde. De même que ces amplificateurs, de tels convertisseurs sont typiquement utilisés dans les noeuds de réseaux de télécommunication à fibres optiques. Lorsque, par exemple, une longueur d'onde dite ci-après primaire a été allouée à un signal pour constituer la longueur d'onde d'une onde optique portant ce signal dans une ligne joignant un premier à un deuxième noeud d'un tel réseau, un tel convertisseur est utilement inclus dans ce deuxième noeud. Il permet alors d'allouer à ce même signal une autre longueur d'onde pour constituer la longueur d'onde d'une autre onde optique portant ce signal dans une autre ligne joignant ce deuxième à un troisième noeud de ce réseau. Une telle réallocation de longueur d'onde est nécessaire dans le cas où cette autre ligne guide déjà un autre signal porté sur la longueur d'onde primaire. De tels convertisseurs peuvent aussi permettre le routage de tels signaux dans chacun des noeuds du réseau.

Il est connu de réaliser de tels convertisseurs sous la forme de puces semiconductrices dont les structures internes sont analogues à celles de ces amplificateurs. Les contraintes techniques relatives à la réalisation de tels convertisseurs sont cependant bien différentes de celles qui concernent les amplificateurs. En particulier des amplificateurs à semiconducteurs fonctionnent typiquement dans un régime linéaire correspondant à une puissance d'entrée comprise entre -40 et -15 dBm alors qu'un tel convertisseur fonctionne dans un régime de saturation correspondant à une puissance de l'onde porteuse primaire supérieure à -15 dBm. De plus l'efficacité du convertisseur est typiquement meilleure lorsque la longueur du guide d'onde contenant son matériau actif est supérieure à 1 mm et plus particulièrement à 1,2 mm alors que la longueur optimale du guide correspondant d'un amplificateur est inférieure à 1 mm et peut être encore utilement nettement abaissée pour maintenir le régime de fonctionnement linéaire en présence de fortes puissances d'entrée.

Pour les raisons qui ont été indiquées ci-avant à propos des amplificateurs, le besoin s'est fait sentir que la bande passante optique d'un tel convertisseur soit élargie. Cette bande est la bande dans laquelle ladite longueur d'onde primaire doit se situer pour que le signal porté sur cette longueur d'onde soit l'objet d'un transfert dans ce convertisseur, ce transfert étant tel que ce signal soit porté en sortie de ce convertisseur sur une onde porteuse secondaire dont la longueur d'onde doit typiquement être située dans la même bande. Elle doit être distinguée de la bande passante de modulation qui est la bande de fréquences dans laquelle un signal doit être situé pour être l'objetdudit transfert.

Un tel convertisseur de longueur d'onde optique connu a été étudié dans une thèse présentée à l'université technique du Danemark : C. J. Videcrantz, Ph. D. Thesis, Optical Amplification and Processing in High-Capacity Photonic Networks, March 1997, LD 124.

Il présente notamment l'inconvénient que sa bande passante optique est rétrécie au voisinage de 30 nm lorsque son facteur de confinement présente une valeur convenable telle que 0,85.

La présente invention a notamment pour but de permettre de réaliser simplement un convertisseur de longueur d'onde ayant une bande passante optique élargie tout en réalisant efficacement le transfert d'un signal d'une onde porteuse optique vers une autre telle onde.

Et dans ce but elle a aussi pour objet un convertisseur de longueur d'onde optique. De même que le convertisseur connu mentionné ci-avant, le convertisseur objet de cette invention comporte un guide d'ondes pour guider en même temps deux ondes optiques constituant respectivement une onde porteuse primaire et une onde auxiliaire. Cette onde porteuse a une longueur d'onde dite ci-après primaire. Elle présente une modulation d'amplitude portant un signal à transmettre et constituant une modulation primaire. Ledit guide d'onde inclut une structure active sensible à ladite modulation primaire pour transformer ladite onde auxiliaire en une onde porteuse secondaire ayant une même longueur d'onde que cette onde auxiliaire tout en ayant une modulation secondaire portant ledit signal à transmettre.

Le convertisseur objet de cette invention est caractérisé par le fait que ladite structure active inclut une pluralité de matériaux actifs sensibles chacun à ladite modulation primaire seulement lorsque ladite longueur d'onde primaire est comprise dans une bande spectrale constituant une bande de gain de ce matériau actif, les dites bandes de gain de ces matériaux actifs étant décalées les unes par rapport aux autres.

Compte tenu du fait que, dans un tel convertisseur, la modulation de l'onde porteuse primaire agit sur l'onde auxiliaire par l'intermédiaire de la modulation d'une densité des porteurs de charges dans la structure active et compte tenu aussi du fait que cette modulation de densité de porteurs s'accompagne au moins localement d'une amplification de cette onde porteuse, une condition pour que le convertisseur soit efficace est que la longueur d'onde de cette onde porteuse soit comprise dans la bande de gain de cette structure. Le décalage qui est réalisé selon cette invention entre les bandes de gain respectives de divers matériaux actifs inclus dans cette structure élargit cette bande de gain. Il élargit donc la bande passante optique du convertisseur. Dans le cas où la modulation secondaire souhaitée en sortie de la puce semiconductrice est une modulation d'amplitude plutôt qu'une modulation de phase, cette invention permet de même d'élargir la bande de longueurs d'onde dans laquelle doit se trouver l'onde auxiliaire. Dans les réseaux de télécommunication à fibres optiques avec multiplexage en longueurs d'onde et allocations successives de longueurs d'onde en cours de routage, ces deux bandes sont typiquement identiques de sorte que l'élargissement de l'une équivaut à l'élargissement de l'autre quel que soit le type de modulation secondaire souhaité en sortie de la puce semiconductrice.

De préférence ladite pluralité de matériaux actifs est incluse dans ladite structure active sous la forme de matériaux massifs. La mise de cette pluralité de matériaux actifs sous cette forme de matériaux massifs facilité la réalisation du convertisseur et présente l'avantage considérable de permettre d'obtenir une bonne efficacité du convertisseur. Cette efficacité est de préférence accrue par le fait par le fait que lesdits matériaux actifs constituent au moins pour partie un coeur dudit guide d'ondes en occupant au moins 80% du volume de ce coeur. Comme dans le cas de l'amplificateur de la présente invention, une telle concentration de matériau actif dans le coeur du guide d'ondes permet de donner une valeur élevée au coéfficient de confinement des ondes dans ce matériau. Dans le cas du convertisseur cette concentration permet de donner au coefficient de confinement des ondes optiques dans les zones optiquement actives une valeur aussi élevée et éventuellement plus élevée que dans le dit convertisseur connu et elle favorise ainsi l'intermodulation qui doit être réalisée entre l'onde porteuse primaire et l'onde auxiliaire.

De préférence ladite pluralité de matériaux actifs est incluse dans ladite structure active sous la forme d'une pluralité de couches homogènes constituées respectivement par ces matériaux. Ces couches constituent respectivement des couches actives qui sont superposées les unes aux autres de préférence avec contact des unes avec les autres. Cette disposition est simple à réaliser et elle permet de donner une valeur maximale à la concentration du matériau actif dans le coeur du guide d'ondes.

A l'aide des figures schématiques ci-jointes on va décrire ci-après divers modes de mise en oeuvre de cette invention.

La figure 1 représente une vue en perspective commune à un premier, un deuxième et un troisième amplificateurs et à un premier, un deuxième, et un troisième convertisseurs selon cette invention.

Les figures 2a, 3a et 4a représentent respectivement des vues en coupes transversales des puces semiconductrices de ces premier, deuxième et troisième amplificateurs ou convertisseurs selon cette invention.

Les figures 2b, 3b et 4b représentent respectivement des diagrammes relatifs aux niveaux d'énergie susceptibles d'être occupés par des électrons à diverses cotes au dessus de substrats desdites puces de ces amplificateurs ou convertisseurs, les énergies de tels niveaux étant portées en ordonnées, ces cotes étant portées en abscisses.

La figure 5 représente une vue de dessus commune à un quatrième, un cinquième et un sixième convertisseurs selon cette invention.

Sur ces figures des flèches indiquent deux dites directions horizontales constituant respectivement une direction longitudinale Z et une direction transversale Y. La dite direction verticale DV a deux sens mutuellement opposés constituant un sens vers le haut X et un sens vers le bas J. Toutes ces directions sont liées à une dite puce semiconductrice.

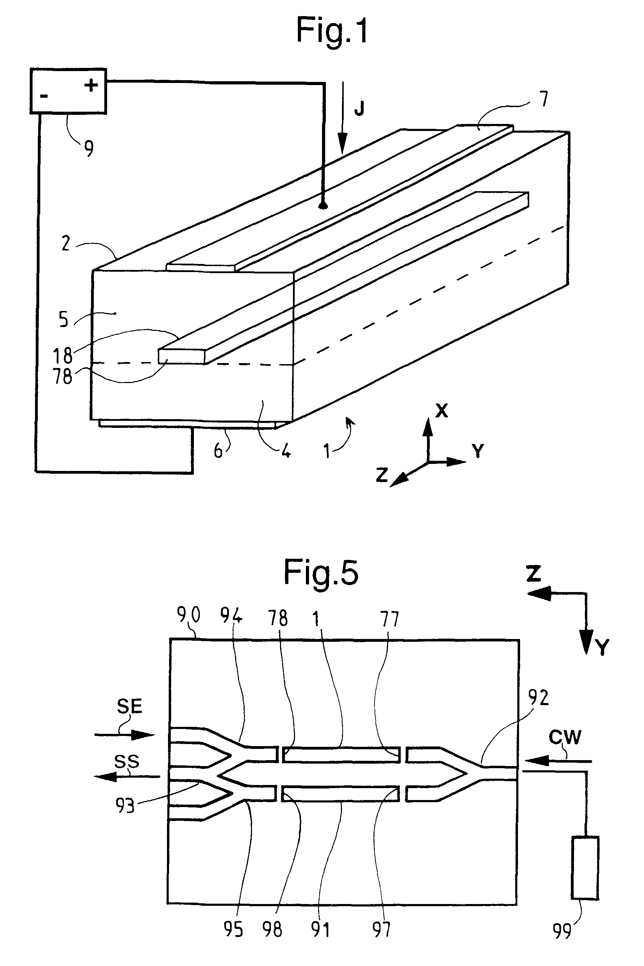

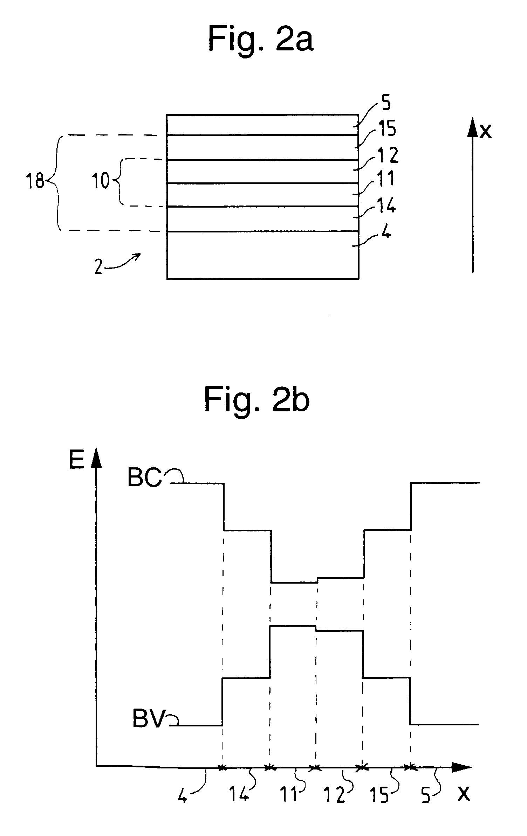

En se référant aux figures 1 et 2a on va tout d'abord décrire, à propos dudit premier amplificateur selon cette invention, des dispositions préférées pour l'ensemble des amplificateurs selon cette invention. Conformément à ces figures ladite succession de couches de la puce semiconductrice 2 d'un tel amplificateur inclut notamment, de même que dans le cas desdits amplificateurs connus, les couches et ensembles de couches suivants qui se succèdent dans ledit sens vers le haut X:
- Un substrat de phosphure d'indium à dopage de type n. Un tel substrat est couramment disponible dans le commerce.
- Ladite couche d'injection inférieure. Cette couche est constituée de phosphure d'indium. Elle a un dopage de type n et une concentration de dopage de 3.10¹⁸ cm⁻³. Le substrat et cette couche sont désignés collectivement sur la figure par la référence 4.
- Un guide d'ondes 18 s'étendant et guidant des ondes optiques selon la direction longitudinale Z et ayant une largeur limitée selon la direction transversale Y. Sur la figure 1 la puce 2 est supposée transparente pour permettre de voir ce guide. Les diverses couches constituant ce guide sont constituées de matériaux quaternaires, c'est à dire plus spécifiquement de phosphures et arséniures d'indium et de gallium. Elles n'ont aucun dopage intentionnel. Elle seront plus précisément décrites plus loin. De même que la couche d'injection inférieure elles ont été formées par des dépôts épitaxiaux successifs sur le substrat. Une gravure a ensuite délimité le guide selon la direction transversale avant le dépôt de la couche suivante. Ce guide d'ondes inclut une structure active 10 pour amplifier lesdites ondes optiques ayant des longueurs d'onde situées dans une bande de gain de cette structure. Cette structure est apte à amplifier ces ondes lorsque ces ondes se propagent dans cette structure en présence de porteurs de charges de chacun des deux types positif et négatif. Elle a un indice de réfraction moyen supérieur à des indices de réfraction de dites couches environnant cette structure pour constituer au moins une partie d'un coeur dudit guide d'ondes.
- Enfin ladite couche d'injection supérieure 5. Cette couche est constituée de phosphure d'indium. Elle a un dopage du type P et une concentration de dopage de 10¹⁸ cm⁻³.

Ledit amplificateur comporte en outre :
- une électrode inférieure 6 formée sur ladite puce,
- une électrode supérieure 7 formée sur cette puce et coopérant avec ladite électrode inférieure pour permettre d'injecter un courant de pompage dans cette puce selon ladite direction verticale, et
- une source de courant 9 pour fournir ledit courant de pompage et pour l'injecter dans ladite puce dans un sens direct J constitué par l'un des deux dits sens de la direction verticale.

Ce sens direct est défini par les types de dopages des dites couches d'injection inférieure et supérieure. Il est tel que ce courant injecte des porteurs de charge des deux dits types dans ladite structure active à partir de ces couches d'injection.

De même que dans ledit deuxième amplificateur connu ladite structure active inclut plusieurs matériaux actifs faisant apparaître une variation de composition au sein de cette structure selon ladite direction verticale. Cette variation de composition s'accompagne de variations correspondantes affectant :
- l'intervalle énergétique local entre bande de valence et bande de conduction,
- la longueur d'onde caractéristique locale, et
- la position spectrale de la bande de gain locale.

De préférence lesdits matériaux actifs sont inclus dans ladite structure active 10 sous la forme d'une pluralité de couches homogènes formant une succession selon ladite direction verticale et constituant des couches actives, à savoir deux telles couches 11 et 12 dans le cas du premier amplificateur objet de l'invention. Cette structure et ces couches ont des épaisseurs respectives. Ces couches ont aussi des compositions définissant respectivement pour ces couches des intervalles énergétiques, des longueurs d'ondes caractéristiques, et des bandes de gain, ces bandes de gain de ces couches se recouvrant partiellement les unes les autres. La réalisation de la structure active sous la forme d'un nombre limité de couches homogènes superposées les unes aux autres présente l'avantage d'être plus facile que sous la forme d'une couche unique plus épaisse dont la composition varierait graduellement selon la direction verticale.
Chacune des dites couches actives offre des gains d'amplification aux dites ondes lumineuses lorsque des porteurs de charge de chacun des deux dits types sont présents dans cette couche active avec des densités respectives suffisantes pour permettre ces gains. Ces gains dépendent des longueurs d'ondes de ces ondes. Ils sont nuls pour les longueurs d'onde extérieures à la bande de gain de cette couche. Il en résulte que ladite bande de gain de la structure active est une bande de gain composite composée par lesdites bandes de gain des dites couches actives. Ces gains dépendent aussi des épaisseurs et des positions de ces couches. Les épaisseurs, positions et compositions respectives de ces couches actives doivent alors être choisies pour qu'un même dit courant de pompage puisse faire apparaître dans chacune de ces couches et pour chacun des deux dits types de porteurs de charges une dite densité suffisante pour permettre un dit gain pour les longueurs d'onde situées dans ladite bande de gain de cette couche.

Certaines limitations apparaissent souhaitables pour cela : De préférence lesdites épaisseurs des dites couches actives 11, 12 sont comprises entre 20 et 400 nm, le nombre de ces couches actives est au plus égal à quatre, et lesdits intervalles énergétiques respectifs de deux quelconques des dites couches actives présentent une différence mutuelle au plus égale à 60 meV.

Dans le cadre de la présente invention et compte tenu des matériaux semiconducteurs commercialement disponibles, il est apparu que le respect des limitations ci-dessus permettait d'obtenir économiquement une répartition suffisamment uniforme de l'injection des porteurs de charges entre les diverses couches actives pour que le gain de la structure soit à peu près uniforme dans toute la bande de gain composite. Cette uniformité d'injection était à réaliser non seulement en ce qui concerne les porteurs de charge négatifs, c'est à dire les électrons, ce qui est facile en raison de la forte mobilité de ces derniers, mais aussi en ce qui concerne les porteurs de charges positifs, c'est à dire les trous, dont la mobilité est moindre. Il n'est en particulier pas apparu nécessaire pour cela de prévoir un dopage de type p pour les couches actives.

En ce qui concerne la limitation concernant la valeur maximale de la différence entre les intervalles énergétiques respectifs de deux couches actives quelconques, et compte tenu du fait que ces intervalles énergétiques définissent les longueurs d'onde caractéristiques de ces couches, il est clair qu'une telle limitation entraine une limitation de la différence correspondante entre ces longueurs d'onde caractéristiques, et donc une limitation de la largeur de la bande gain composite. Mais il doit être noté que, pour une valeur donnée de la différence maximale entre deux dits intervalles énergétiques, la différence maximale entre les longueurs d'onde caractéristiques correspondantes est d'autant plus grande que la longueur d'onde moyenne de la bande de gain composite est plus grande. Il en résulte qu'une telle limitation est peu gênante en pratique lorsque la bande de gain souhaitée est située autour de 1500 nm, ce qui est le cas dans de nombreux réseaux de télécommunication à fibres optiques.

De préférence au moins 80% dudit coeur 10 du guide d'ondes est constitué par lesdites couches actives. Dans la mesure où ce coeur est constitué par ladite structure active, ceci revient à dire que ces couches sont plus proches les unes des autres au sein de cette structure que ne le seraient des puits quantiques séparés par des barrières. Plus particulièrement lesdites couches actives 11, 12 sont superposées avec contact entre couches successives. Une telle proximité, allant de préférence jusqu'à un tel contact, entre des couches actives ayant des indices de réfraction accrus, c'est à dire supérieurs à ceux des couches environnantes, permet de donner une valeur élevée au coefficient de confinement qui représente la proportion dans laquelle les ondes optiques sont confinées dans le matériau actif. Elle favorise ainsi l'action d'amplification.

De préférence ledit guide d'ondes inclut successivement selon ladite direction verticale dans ledit sens vers le haut X :
- une couche de confinement inférieure 13 ayant un indice de réfraction et une longueur d'onde caractéristique respectivement inférieures à chacun desdits indices de réfraction et à chacune des dites longueurs d'onde caractéristiques des dites couches actives,
- ladite structure active 10, et
- une couche de confinement supérieure 14 ayant un indice de réfraction et une longueur d'onde caractéristique respectivement inférieures à chacun desdits indices de réfraction et à chacune des dites longueurs d'onde caractéristiques des dites couches actives.

Les longueurs d'onde caractéristiques de ces couches de confinement sont alors extérieures à ladite bande de gain composite et chacune de ces couches de confinement est en contact avec une dite couche active.

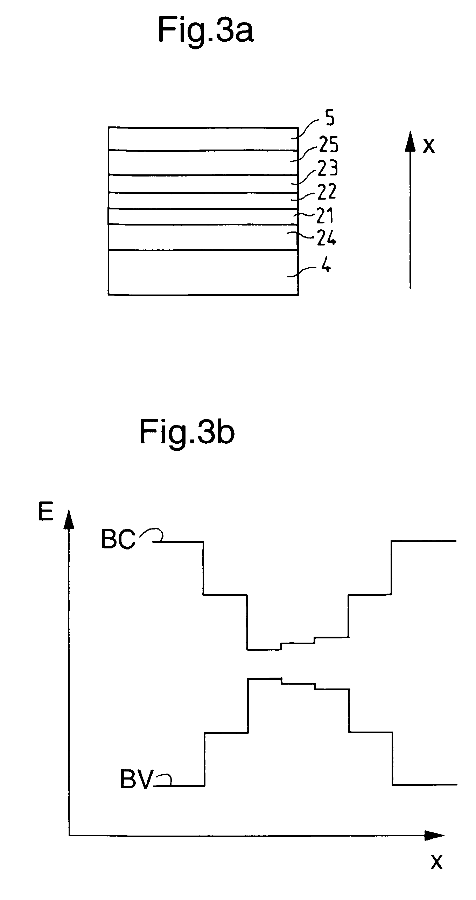

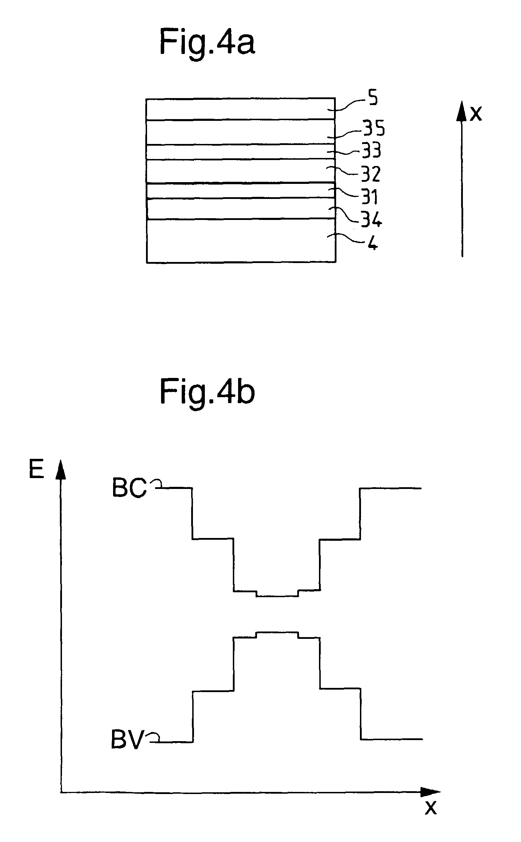

La répartition des longueurs d'onde caractéristiques de diverses couches est indirectement illustrée sur les figures 2b, 3b, 4b. Sur ces figures les intervalles énergétiques des divers matériaux sont représentés par les distances verticales s'étendant entre la limite inférieure BC de la bande de conduction et la limite supérieure BV de la bande de valence. Les longueurs d'onde caractéristiques sont inversement proportionnelles à ces intervalles.

Toutes les couches desdits guides d'onde ont des compositions répondant à la formule GaₓIn₁₋ₓAs_{y}P_{1-y}.

Chacune desdites couches de confinement a par exemple une épaisseur égale à 100 nm. Sa composition est définie par les valeurs x= 0,2 et y = 0,44, ce qui lui donne un indice de réfraction voisin de 3,2 et une longueur d'onde caractéristique égale à 1180 nm environ.

L'insertion de telles couches de confinement entre de telles couches d'injection et une structure active est une disposition connue en elle même pour la réalisation d'amplificateurs optiques à semiconducteur. Elle a pour effet de contribuer à confiner les porteurs de charges dans un volume qui contient la structure active. Ce volume est celui du guide optique 18 dont un coeur est constitué par cette structure active et dont une gaine est constituée par les dites couches de confinement. Cet effet est particulièrement souhaitable dans le cadre de cette invention dans le but d'éviter que la densité de porteurs de charge à faible mobilité devienne insuffisante dans une couche active.

Une autre disposition est préférée dans le même but. Pour la décrire il faut considérer que ladite structure active 10 inclut successivement selon ladite direction verticale dans ledit sens direct J :
- une première dite couche active 12 et
- une deuxième dite couche active 11.

Cette disposition est alors constituée par le fait que ladite longueur d'onde caractéristique de ladite première couche active est plus petite que celle de ladite deuxième couche active. Elle a pour but d'augmenter la probabilité pour que les trous qui sont injectés à partir de la couche d'injection à dopage du type p atteignent cette deuxième couche active. Il est utile d'atteindre ce but parce que la probabilité doit être suffisante pour permettre audit courant de pompage de maintenir ladite densité suffisante de ces trous dans cette deuxième couche active. Il est atteint grâce au fait que l'intervalle énergétique relativement élevé de cette première couche active donne une valeur relativement faible à la probabilité pour que ces trous se recombinent avec des électrons pendant leur parcours à travers cette première couche.

De préférence les dites épaisseurs respectives des dites couches actives 11, 12 sont comprises entre 50 et 200 nm environ, ledit nombre de ces couches actives est au plus égal à trois, ladite différence entre les intervalles énergétiques respectifs de deux quelconques de ces couches actives est au plus égale à 40 meV, et ledit courant de pompage a une intensité surfaçique comprise entre 10 et 50 kA/cm2 environ.

De préférence parmi celles des dites couches qui constituent ledit guide d'ondes 18, au moins lesdites couches actives subissent une contrainte suffisante pour rendre un gain dudit amplificateur insensible à une polarisation des dites ondes optiques parcourant ce guide.

Une telle contrainte est utilisée dans des amplificateurs connus pour rendre le gain d'une couche active insensible à la polarisation éventuelle d'ondes optiques se propageant dans cette couche. Une telle insensibilité est recherchée dans les réseaux de communication à fibres optiques parce que les ondes reçues dans un noeud d'un tel réseau en sortie d'une ligne de grande longueur présentent le plus souvent une polarisation et parce que cette polarisation est aléatoire quant à son degré et quant à sa direction. La contrainte souhaitée est obtenue par le choix d'une composition convenable de la couche à contraindre parce que ce choix permet de donner à la maille cristalline du matériau de cette couche une dimension naturelle différente de celle des matériaux des autres couches de la puce semiconductrice, cette dimension naturelle étant celle qui apparaîtrait en l'absence de contrainte. La continuité cristalline entre les diverse couches de la puce impose alors à la maille du matériau de la couche à contraindre une dimension modifiée qui est sensiblement égale à la dimension naturelle de la maille de ces autres couches et cette modification de dimension s'accompagne de la réalisation de la contrainte souhaitée. Le choix de la dimension de maille d'un matériau quaternaire ayant une formule chimique telle que GaₓIn₁₋ₓAs_{y}P_{1-y} est compatible avec le choix de l'intervalle énergétique de ce matériau malgré le fait que ces deux choix sont faits par l'intermédiaire de la composition de ce matériau. Cette compatibilité résulte de la présence dans cette formule de deux paramètres x et y pouvant être choisis indépendamment l'un de l'autre.

Typiquement le guide d'ondes 18 d'un amplificateur selon cette invention a une longueur comprise entre 0,3 et 1 mm. Cette longueur est mesurée selon ladite direction longitudinale et elle est typiquement égale à celle de la puce 2. La largeur de ce guide est alors typiquement comprise entre 1 000 et 1 500 nm.

Dans le cas dudit premier amplificateur selon cette invention ladite structure active 10 est constituée par deux couches qui sont une couche active inférieure 11 et une couche active supérieure 12 et qui ont une même épaisseur égale à 100 nm.

La composition du matériau de la couche 11 est définie par les valeurs x = 0,44 et y = 0,89. Elle donne à ce matériau un indice de réfraction voisin de 3,5 et une longueur d'onde caractéristique égale à 1530 nm. De même que pour les autres couches actives décrites ci-après cet indice de réfraction indiqué pour la couche 11 est celui qui est vu par la lumière du composant lorsque ledit courant de pompage circule à travers la puce.

Pour la couche 12 la formule chimique est définie par les valeurs x = 0,45 et y = 0,92. Elle donne au matériau un indice de réfraction voisin de 3,5 et une longueur d'onde caractéristique égale à 1560 nm.

Les deuxième et troisième amplificateurs selon la présente invention différent du premier seulement par la constitution de leurs structures actives respectives, lesdites couches de confinement 24 et 25 de ce deuxième amplificateur et 34 et 35 de ce troisième amplificateur étant respectivement identiques aux couches 14 et 15 précédemment décrites.

Ce deuxième amplificateur comporte trois couches actives ayant une même épaisseur égale à 67 nm. Le matériau d'une couche active inférieure 21 a une composition définie par les valeurs x = 0,46 et y = 0,95. Il a un indice de réfraction voisin de 3,5 et une longueur d'onde caractéristique de 1590 nm. Celui d'une couche active intermédiaire 22 a la même composition que la couche 12, un indice de réfraction voisin de 3,5, et une longueur d'onde caractéristique de 1560 nm. Enfin celui d'une couche active supérieure 23 a la même composition que la couche 11, un indice de réfraction voisin de 3,5 et une longueur d'onde caractéristique de 1530 nm.

Le troisième amplificateur selon cette invention comporte lui aussi trois couches actives.

Une couche active inférieure 31 a une épaisseur égale à 50 nm. Sa composition est la même que celle de la couche 11 et lui donne un indice de réfraction voisin de 3,5 et une longueur d'onde caractéristique de 1530 nm.

Une couche active intermédiaire 32 a une épaisseur égale à 100 nm. Sa composition est la même que celle de la couche 12 et lui donne un indice de réfraction voisin de 3,5 et une longueur d'onde caractéristique de 1560 nm.

Enfin une couche active supérieure 33 est identique à la couche 31.

Les premier, deuxième et troisième dits convertisseurs selon la présente invention correspondent respectivement aux premier, deuxième et troisième amplificateurs qui ont été décrits ci-dessus. Chaque tel convertisseur comporte une dite puce semiconductrice avec les dites électrodes et la dite source de courant pour fournir à cette puce son dit courant de pompage, cette puce ne différant de la puce de l'amplificateur correspondant que par la longueur et la largeur dudit guide d'ondes.

En se référant aux figures 1 et 5 ledit guide d'ondes 18 de ce convertisseur s'étend selon une direction longitudinale Z, entre :
- un port arrière 77 pour recevoir ladite onde auxiliaire CW sous la forme d'une onde continue dépourvue de modulation, et
- un port avant 78 pour recevoir ladite onde porteuse primaire SE et pour fournir ladite onde porteuse secondaire. Cette disposition est connue en elle même et elle est dite "contradirectionnelle" parce que l'onde porteuse primaire et l'onde auxiliaire circulent dans deux sens opposés. Elle permet notamment d'allouer une même longueur d'onde à ces deux ondes lorsque cela est utile.

Le guide d'ondes d'un tel convertisseur présente typiquement une longueur comprise entre 1 et 4 mm et de préférence entre 1,5 et 2,5 mm, cette longueur étant mesurée selon ladite direction longitudinale et étant typiquement celle de la puce de ce convertisseur. La largeur de ce guide est typiquement comprise entre 1 000 et 1 500 nm.

Un tel convertisseur réalise une intermodulation entre l'onde porteuse primaire et l'onde de référence. Il peut donc être désigné, pour clarifier la suite de la présente description, par l'appelation "dispositif d'intermodulation".

Les quatrième, cinquième et sixième dits convertisseurs selon cette invention comportent de tels dispositifs d'intermodulation. Ces derniers sont respectivement identiques aux premier, deuxième et troisième convertisseurs décrits ci-avant.

Conformément à la figure 5, et dans le cas de chacun des dits quatrième, cinquième et sixième convertisseurs, le convertisseur considéré comporte une base 90 et, sur cette base :
- ledit dispositif d'intermodulation 1,
- un amplificateur de référence 91 sensiblement identique à ce dispositif d'intermodulation et constitué d'éléments ayant respectivement des mêmes fonctions et des mêmes dénominations que des éléments correspondants de ce dispositif, et
- des guides d'ondes optiques constituant :
- un coupleur en Y constituant un coupleur arrière 92 pour recevoir une onde ayant la longueur d'onde souhaitée pour ladite onde auxiliaire CW et pour transmettre deux parties égales de cette onde respectivement audit port arrière 77 dudit dispositif d'intermodulation pour constituer ladite onde auxiliaire et au port arrière 97 correspondant dudit amplificateur de référence pour constituer une onde de référence et pour que cette onde de référence soit transformée par cet amplificateur de référence en une onde de référence amplifiée, et
- un coupleur avant composite comportant :
- un coupleur en Y constituant un coupleur de sortie 93 pour recevoir la dite onde porteuse secondaire à partir dudit port avant 78 dudit dispositif d'intermodulation et ladite onde de référence amplifiée à partir du port avant 98 correspondant dudit amplificateur de référence et pour fournir en sortie dudit convertisseur une onde de sortie SS constituée par la réunion et par l'interférence de cette onde porteuse secondaire et de cette onde de référence amplifiée, et
- un coupleur en Y constituant un coupleur d'entrée 94 pour recevoir ladite onde porteuse primaire en entrée dudit convertisseur et pour la transmettre audit port avant (78) dudit dispositif d'intermodulation.

Le convertisseur ainsi constitué présente la forme d'un interféromètre de Mach-Zehnder. Son fonctionnement résulte du fait que la modulation secondaire comporte une modulation de phase. Cette dernière est induite par la modulation de la densité de porteurs de charges qui est provoquée par les variations de l'intensité de l'onde porteuse primaire. Elle entraine par interférence une modulation d'amplitude de l'onde de sortie. Ce fonctionnement nécessite donc un équilibrage des intensités respectives de l'onde porteuse secondaire et de l'onde de référence amplifiée. Cet équilibrage est obtenu par des moyens connus tels qu'une régulation de l'intensité de l'onde de référence amplifiée par action sur le courant de pompage de l'amplificateur de référence. Une fraction de cette dernière onde peut pour cela être prélevée par l'intermédiaire d'un coupleur auxiliaire 95.

Chacun des convertisseurs décrits ci-avant comporte en outre une source optique 99 pour fournir ladite onde auxiliaire CW.

## Revendications

1. Composant optique à semiconducteur, ce composant comportant un guide d'ondes (18) faisant partie d'une puce semiconductrice (2) constituée de couches s'étendant selon des directions horizontales (Y,Z) de cette puce et formant une succession présentant une continuité cristalline selon une direction verticale (X) de cette puce, ce guide d'ondes s'étendant selon une dite direction horizontale (Z) et incluant des matériaux actifs (11, 12), ces matériaux ayant des compositions et des intervalles énergétiques respectifs les rendant aptes à amplifier des ondes optiques se propageant dans ce guide, ces matériaux présentant selon ladite direction verticale une variation de composition entrainant une variation d'intervalle énergétique,
ce composant étant caractérisé par le fait que certains au moins desdits matériaux actifs sont inclus dans ledit guide d'ondes sous la forme de matériaux massifs.

2. Composant optique selon la revendication 1, ce composant constituant un amplificateur optique, ladite direction verticale (DV) ayant deux sens mutuellement opposés constituant un sens vers le haut (X) et un sens vers le bas (J), ladite succession de couches incluant dans ledit sens vers le haut:
- une couche d'injection inférieure (4) ayant un dopage d'un premier type de conductivité,
- une structure active (10) incluant les dits matériaux actifs pour amplifier des dites ondes optiques ayant des longueurs d'onde situées dans une bande de gain de cette structure, cette structure étant apte à amplifier ces ondes lorsque ces ondes se propagent dans cette structure en présence de porteurs de charges de chacun des deux types positif et négatif, cette structure ayant un indice de réfraction moyen supérieur à des indices de réfraction de dites couches environnant cette structure pour constituer au moins une partie d'un coeur dudit guide d'ondes (18), et
- une couche d'injection supérieure (5) ayant un dopage du deuxième type de conductivité,
ledit amplificateur comportant en outre :
- une électrode inférieure (6) formée sur ladite puce,
- une électrode supérieure (7) formée sur cette puce et coopérant avec ladite électrode inférieure pour permettre d'injecter un courant de pompage dans cette puce selon ladite direction verticale, et
- une source de courant (9) pour fournir ledit courant de pompage et pour l'injecter dans ladite puce dans un sens direct (J) constitué par l'un des deux dits sens de la direction verticale, ce sens direct étant défini par les dits types de dopages des dites couches d'injection et étant tel que ce courant injecte des porteurs de charge des deux dits types dans ladite structure active à partir de ces couches d'injection,
ledit amplificateur étant caractérisé par le fait que lesdits matériaux actifs sont inclus dans ladite structure active (10) sous la forme d'une pluralité de couches homogènes formant une succession selon ladite direction verticale et constituant respectivement des couches actives (11, 12), cette structure et ces couches ayant des épaisseurs respectives, ces couches ayant aussi des compositions définissant respectivement pour ces couches des intervalles énergétiques, des longueurs d'ondes caractéristiques, et des bandes de gain, ces bandes de gain de ces couches se recouvrant partiellement les unes les autres, chacune de ces couches actives offrant des gains d'amplification aux dites ondes optiques lorsque à la fois les longueurs d'ondes de ces ondes sont comprises dans la bande de gain de cette couche et des porteurs de charge de chacun des deux dits types sont présents dans cette couche active avec des densités respectives suffisantes pour permettre ces gains, grâce à quoi ladite bande de gain de la structure active est une bande de gain composite composée par lesdites bandes de gain des dites couches actives.

3. Amplificateur optique selon la revendication 2, cet amplificateur étant caractérisé par le fait que lesdites épaisseurs des dites couches actives (11, 12) sont comprises entre 20 et 400 nm, le nombre de ces couches actives étant au plus égal à quatre, lesdits intervalles énergétiques respectifs de deux quelconques des dites couches actives présentant une différence mutuelle au plus égale à 60 meV.

4. Amplificateur optique selon la revendication 3, cet amplificateur étant caractérisé par le fait qu'au moins 80% du volume dudit coeur (10) dudit guides d'ondes est constituée par lesdites couches actives.

5. Amplificateur optique selon la revendication 4 cet amplificateur étant caractérisé par le fait que lesdites couches actives (11, 12) sont superposées avec contact entre couches successives.

6. Amplicateur optique selon la revendication 5, cet amplificateur étant caractérisé par le fait que ladite succession de couches inclut selon ladite direction verticale dans ledit sens vers le haut (X) :
- ladite couche d'injection inférieure (4),
- une couche de confinement inférieure (13) ayant un indice de réfraction et une longueur d'onde caractéristique, respectivement inférieures à chacun desdits indices de réfraction et à chacune des dites longueurs d'onde caractéristiques des dites couches actives,
- ladite structure active (10),
- une couche de confinement supérieure (14) ayant un indice de réfraction et une longueur d'onde caractéristique respectivement inférieures à chacun desdits indices de réfraction et à chacune des dites longueurs d'onde caractéristiques des dites couches actives, et
- ladite couche d'injection supérieure (5),
lesdites longueurs d'onde caractéristiques des couches de confinement étant extérieures à ladite bande de gain composite, chacune de ces couches de confinement étant en contact avec une dite couche active.

7. Amplificateur optique selon la revendication 6, amplificateur dans lequel ladite structure active (10) inclut successivement selon ladite direction verticale dans ledit sens direct (J) :
- une première dite couche active (12), et
- une deuxième dite couche active (11),
cet amplificateur étant caractérisé par le fait que ladite longueur d'onde caractéristique de ladite première couche active est plus petite que celle de ladite deuxième couche active.

8. Amplificateur optique selon la revendication 3, cet amplificateur étant caractérisé par le fait que les dites épaisseurs respectives des dites couches actives (11, 12) sont comprises entre 50 et 200 nm environ, ledit nombre de ces couches actives étant au plus égal à trois, ladite différence entre les intervalles énergétiques respectifs de deux quelconques de ces couches actives étant au plus égale à 40 meV, ledit courant de pompage ayant une intensité surfaçique comprise entre 10 et 50 kA/cm2 environ.

9. Amplificateur optique selon la revendication 6, cet amplificateur étant caractérisé par le fait que les dites couches d'injection inférieure (4) et supérieure (5) sont constituées d'un composé semiconducteur binaire du type III-V, les dites couches actives (11, 12) et les dites couches de confinement (14, 15) étant constituées de composés quaternaires du type arséniure et phosphure d'indium et de gallium avec des proportions respectives de l'arsénic par rapport au phosphore et de l'indium par rapport au gallium, ces couches actives et de confinement étant dépourvues de dopage intentionnel.

10. Amplificateur optique selon la revendication 2, cet amplificateur étant caractérisé par le fait que, parmi celles des dites couches qui constituent ledit guide d'ondes (18), au moins lesdites couches actives subissent une contrainte suffisante pour rendre un gain dudit amplificateur insensible à une polarisation des dites ondes optiques parcourant ce guide.

11. Amplificateur optique selon la revendication 2, cet amplificateur étant caractérisé par le fait que ledit guide d'ondes (18) présente une longueur comprise entre 0,3 et 1 mm.

12. Composant selon la revendication 1, ce composant constituant un convertisseur de longueur d'onde optique, ce convertisseur comportant des moyens pour permettre audit guide d'ondes (18) de guider en même temps deux ondes optiques constituant respectivement une onde porteuse primaire(SE) et une onde auxiliaire (CW), cette onde porteuse ayant une longueur d'onde primaire et ayant une modulation d'amplitude portant un signal à transmettre et constituant une modulation primaire, ce guide d'onde incluant une structure active (10) sensible à ladite modulation primaire pour transformer ladite onde auxiliaire en une onde porteuse secondaire ayant une même longueur d'onde que cette onde auxiliaire tout en ayant une modulation secondaire portant ledit signal à transmettre,
ledit convertisseur de longueur d'onde optique étant caractérisé par le fait que ladite structure active inclut une pluralité de matériaux actifs (11, 12) sensibles chacun à ladite modulation primaire seulement lorsque ladite longueur d'onde est comprise dans une bande spectrale constituant une bande de gain de ce matériau actif, les dites bandes de gain de ces matériaux actifs étant décalées les unes par rapport aux autres.

13. Convertisseur de longueur d'onde optique selon la revendication 12, ce convertisseur étant caractérisé par le fait que ladite pluralité de matériaux actifs est incluse dans ladite structure active (10) sous la forme de matériaux massifs.

14. Convertisseur de longueur d'onde optique selon la revendication 13, ce convertisseur étant caractérisé par le fait que lesdits matériaux actifs (11, 12) constituent au moins pour partie un coeur (10) dudit guide d'ondes (18) et occupent au moins 80% de ce coeur.

15. Convertisseur de longueur d'onde optique selon la revendication 13, ce convertisseur étant caractérisé par le fait que ladite pluralité de matériaux actifs est incluse dans ladite structure active (10) sous la forme d'une pluralité de couches homogènes constituées respectivement par ces matériaux actifs et constituant respectivement des couches actives (11, 12), ces couches actives étant superposées les unes aux autres.

16. Convertisseur de longueur d'onde optique selon la revendication 15, ce convertisseur étant caractérisé par le fait que lesdites couches actives (11,12) sont superposées avec contact des unes avec les autres.

17. Convertisseur de longueurs d'onde optique selon la revendication 12, ledit guide d'ondes (18) de ce convertisseur s'étendant selon une direction longitudinale (Z) entre :
- un port arrière (77) pour recevoir ladite onde auxiliaire (CW) sous la forme d'une onde continue dépourvue de modulation, et
- un port avant (78) pour recevoir ladite onde porteuse primaire (SE) et pour fournir ladite onde porteuse secondaire,
ledit convertisseur étant caractérisé par le fait qu'il est conforme à un amplificateur optique selon l'une quelconque des revendications 2 à 10, ladite puce semiconductrice, ledit guide d'ondes et ladite structure active de cet amplificateur constituant en même temps respectivement ladite puce semiconductrice (2), ledit guide d'ondes (18) et ladite structure active (10) de ce convertisseur, ce convertisseur constituant un dispositif d'intermodulation (1).

18. Convertisseur de longueur d'onde optique selon la revendication 17, ce convertisseur étant caractérisé par le fait que ledit guide d'ondes (18) présente selon ladite direction longitudinale (Z) une longueur comprise entre 1 et 4 mm.

19. Convertisseur selon la revendication 18, ce convertisseur étant caractérisé par le fait que ladite longueur dudit guide d'ondes (18) est comprise entre 1,5 et 2,5 mm.

20. Convertisseur de longueur d'onde optique selon la revendication 17, ce convertisseur étant caractérisé par le fait qu'il comporte une base (90) et, sur cette base :
- ledit dispositif d'intermodulation (1),
- un amplificateur de référence (91) sensiblement identique à ce dispositif d'intermodulation et constitué d'éléments ayant respectivement des mêmes fonctions et des mêmes dénominations que des éléments correspondants de ce dispositif d'intermodulation, et
- des guides d'ondes optiques constituant :
- un coupleur en Y constituant un coupleur arrière (92) pour recevoir une onde ayant la longueur d'onde souhaitée pour ladite onde auxiliaire (CW) et pour transmettre deux parties égales de cette onde respectivement audit port arrière (77) dudit dispositif d'intermodulation pour constituer ladite onde auxiliaire et au port arrière (97) correspondant dudit amplificateur de référence pour constituer une onde de référence et pour que cette onde de référence soit transformée par cet amplificateur de référence en une onde de référence amplifiée, et
- un coupleur avant composite comportant :
- un coupleur en Y constituant un coupleur de sortie (93) pour recevoir la dite onde porteuse secondaire à partir dudit port avant (78) dudit dispositif d'intermodulation et ladite onde de référence amplifiée à partir du port avant (98) correspondant dudit amplificateur de référence et pour fournir en sortie dudit convertisseur une onde de sortie (SS) constituée par la réunion et par l'interférence de cette onde porteuse secondaire et de cette onde de référence amplifiée, et
- un coupleur en Y constituant un coupleur d'entrée (94) pour recevoir ladite onde porteuse primaire en entrée dudit convertisseur et pour la transmettre audit port avant (78) dudit dispositif d'intermodulation.

21. Convertisseur de longueur d'onde optique selon l'une quelconque des revendications 12 à 20, ce convertisseur comportant en outre une source optique (99) pour fournir ladite onde auxiliaire (CW).
